(19) Europäisches Patentamt
European Patent Office
Office européen des brevets

(11) **EP 3 462 198 B1**

(12) **FASCICULE DE BREVET EUROPEEN**

(45) Date de publication et mention de la délivrance du brevet:
**29.07.2020 Bulletin 2020/31**

(51) Int Cl.:
*G01R 31/317* *(2006.01)*     *G01R 23/00* *(2006.01)*
*G01R 23/16* *(2006.01)*

(21) Numéro de dépôt: **18197120.1**

(22) Date de dépôt: **27.09.2018**

(54) **PROCÉDÉ DE DETERMINATION DE PARAMETRES CARACTERISTIQUES D'UN OSCILLATEUR**

VERFAHREN ZUR BESTIMMUNG DER CHARAKTERISTISCHEN PARAMETER EINES OSZILLATORS

METHOD FOR DETERMINING CHARACTERISTIC PARAMETERS OF AN OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.09.2017 FR 1759010**

(43) Date de publication de la demande:
**03.04.2019 Bulletin 2019/14**

(73) Titulaire: **Commissariat à l'Energie Atomique et aux Energies Alternatives
75015 Paris (FR)**

(72) Inventeur: **NOWODZINSKI, Antoine
38134 SAINT JOSEPH DE RIVIERE (FR)**

(74) Mandataire: **Cabinet Camus Lebkiri
25 rue de Maubeuge
75009 Paris (FR)**

(56) Documents cités:
**US-B1- 8 686 802**

- **WEN-MING ZHANG ET AL: "Nonlinear Dynamic Analysis of Electrostatically Actuated Resonant MEMS Sensors Under Parametric Excitation", IEEE SENSORS JOURNAL, IEEE SERVICE CENTER, NEW YORK, NY, US, vol. 7, no. 3, 1 mars 2007 (2007-03-01), pages 370-380, XP011163489, ISSN: 1530-437X**
- **ALI H NAYFEH ET AL: "Dynamics of MEMS resonators under superharmonic and subharmonic excitations; Dynamics of resonators under superharmonic and subharmonic excitations", JOURNAL OF MICROMECHANICS & MICROENGINEERING, INSTITUTE OF PHYSICS PUBLISHING, BRISTOL, GB, vol. 15, no. 10, 1 octobre 2005 (2005-10-01), pages 1840-1847, XP020091372, ISSN: 0960-1317, DOI: 10.1088/0960-1317/15/10/008**
- **HASSEN M. OUAKAD ET AL: "The dynamic behavior of MEMS arch resonators actuated electrically", INTERNATIONAL JOURNAL OF NON-LINEAR MECHANICS, vol. 45, no. 7, 1 septembre 2010 (2010-09-01), pages 704-713, XP055415795, AMSTERDAM, NL ISSN: 0020-7462, DOI: 10.1016/j.ijnonlinmec.2010.04.005**

**Description**

**DOMAINE TECHNIQUE DE L'INVENTION**

La présente invention concerne un procédé de détermination de paramètres caractéristiques d'un oscillateur, tels que la fréquence de résonance et le facteur de qualité.

**ARRIÈRE-PLAN TECHNOLOGIQUE DE L'INVENTION**

Un oscillateur à actionnement électrostatique de type microsystème ou nanosystème électromécanique, respectivement MEMS (« microelectromechanical system » en anglais) ou NEMS (« nanoelectromechanical system » en anglais), est un dispositif comprenant un élément mobile pouvant être mis en oscillation.

De tels oscillateurs consomment peu d'énergie et présentent un encombrement réduit. Ils trouvent donc une application particulièrement avantageuse dans des objets nomades tels que des téléphones intelligents (smartphones) ou des tablettes numériques. Ces oscillateurs sont en particulier utilisés pour fabriquer des capteurs inertiels, comme des accéléromètres ou des gyromètres, destinés à équiper de tels objets.

Un objet nomade peut par ailleurs être équipé d'un système de localisation par satellite (GPS pour « Global Positionning System » en anglais) qui consomme beaucoup d'énergie. Les capteurs inertiels permettent de calculer en temps réel les déplacements de l'objet et donc de réduire le recours au système de localisation par satellite. Ce dernier reste cependant utile pour déterminer une position de référence de l'objet, par exemple à des intervalles de temps réguliers.

L'oscillateur à actionnement électrostatique comporte des moyens d'actionnement qui transforment un signal d'excitation appliqué en entrée de l'oscillateur en une force d'actionnement électrostatique, également appelée « force d'excitation », agissant sur l'élément mobile. Les déplacements de l'élément mobile sont mesurés par des moyens de détections qui génèrent un signal de réponse en sortie de l'oscillateur. Le signal d'excitation et le signal de réponse se présentent par exemple sous la forme de tensions.

L'oscillateur est caractérisé par deux paramètres essentiels, à savoir une fréquence de résonance et un facteur de qualité. En effet, les oscillations de l'élément mobile sont régies par des équations de mouvement qui sont modifiées lorsqu'une force externe, par exemple due à une accélération ou à un effet gyroscopique, s'exerce sur l'élément mobile. La fréquence de résonance est alors également modifiée. En connaissant la fréquence de résonance initiale de l'oscillateur, il est donc possible de quantifier la force externe appliquée.

De plus, il est préférable d'exciter l'oscillateur à une fréquence proche de la fréquence de résonance de manière à maximiser l'amplitude des oscillations. La force s'exerçant sur l'élément mobile peut ainsi être détectée plus facilement, et la sensibilité du capteur est améliorée.

Le facteur de qualité de l'oscillateur a quant à lui une influence sur la précision du capteur inertiel. Plus le facteur de qualité est élevé, plus le capteur est précis et plus il est possible par exemple de limiter l'utilisation du système de localisation par satellite.

Il est donc important de mesurer la fréquence de résonance et le facteur de qualité de l'oscillateur, notamment pour valider le développement et la fabrication du capteur inertiel.

Une première méthode de mesure de la fréquence de résonance et du facteur de qualité consiste à exciter l'oscillateur au moyen d'une tension d'excitation sinusoïdale de fréquence $F_0$ et à mesurer l'amplitude des oscillations à la fréquence $2F_0$. L'amplitude des oscillations est mesurée à la fréquence $2F_0$ car la force d'actionnement électrostatique est proportionnelle au carré de la tension d'excitation. En balayant une plage de fréquence, on obtient une densité spectrale d'amplitude des oscillations à partir de laquelle la fréquence de résonance peut être déterminée. En effet, la densité spectrale d'amplitude forme un pic de résonance présentant un maximum d'amplitude atteint à la fréquence de résonance. Le facteur de qualité peut quant à lui être déterminé à partir de la largeur du pic de résonance considérée à la moitié de sa hauteur.

Un inconvénient de cette méthode de mesure par balayage en fréquence est que pour mesurer correctement l'amplitude des oscillations, l'oscillateur doit retrouver une position de repos entre deux mesures successives. Le temps nécessaire pour que l'oscillateur retrouve sa position de repos après excitation est approximativement égal à trois fois une constante d'amortissement qui est proportionnelle au facteur de qualité. En considérant par exemple un facteur de qualité de l'ordre de $10^6$, la constante d'amortissement est de l'ordre de 10 secondes. Dans ce cas, il faut par exemple plus de 2 heures pour acquérir 250 points de mesure.

Par ailleurs, la précision avec laquelle le pic de résonance est défini dépend du nombre de points de mesure. Si le nombre de points n'est pas suffisant, le pic de résonance peut être élargi artificiellement et son maximum d'amplitude peut être décalé en fréquence, ce qui fausse la mesure de la fréquence de résonance et du facteur de qualité.

Le temps nécessaire pour mettre en œuvre cette méthode de mesure est donc un facteur limitant la productivité, d'autant plus que la tendance actuelle est à l'augmentation du facteur de qualité des oscillateurs. Ce temps de mesure ne permet raisonnablement pas, en particulier d'un point de vue industriel, de caractériser tous les oscillateurs d'une plaque de silicium qui en comporte généralement plus d'une centaine. Seuls quelques oscillateurs sont alors caractérisés, ce qui rend difficile d'estimer un rendement de fabrication des oscillateurs.

Le document de Wen-Ming Zhang et al., "Nonlinear Dynamic Analysis of Electrostatically Actuated Resonant MEMS Sensors Under Parametric Excitation", IEEE Sensors Journal, vol. 7, no. 3, 1 mars 2007 (2007-03-01), pages 370-380, divulgue une méthode d'analyse dynamique non linéaire d'un oscillateur MEMS dans laquelle une tension d'excitation, résultant de la somme d'une tension continue et d'une tension sinusoïdale, est générée et appliquée à l'entrée de l'oscillateur. Ce document montre l'effet de la variation de la tension continue et de l'amplitude de la tension sinusoïdale sur les caractéristiques de l'oscillateur telles que la fréquence de résonance.

Une deuxième méthode de mesure, dite « par impulsion à bande large », de la fréquence de résonance et du facteur de qualité consiste à exciter l'oscillateur au moyen d'une impulsion de tension et à acquérir le signal de réponse généré par l'oscillateur. En effet, une impulsion dans le domaine temporel correspond à une amplitude constante dans le domaine fréquentielle. En pratique, l'impulsion présente plutôt une largeur de bande spectrale élevée. Par conséquent, en calculant la transformée de Fourier du signal acquis, il est possible de localiser le pic de résonance présent dans la bande spectrale de l'impulsion. Il s'agit d'une méthode de mesure rapide puisque l'acquisition peut durer seulement quelques secondes.

Selon cette méthode, la durée d'acquisition détermine directement la résolution fréquentielle de la mesure. Par exemple, une durée d'acquisition de 1 seconde donne une résolution de 1 hertz, et une durée d'acquisition de 100 secondes donne une résolution de 0,01 hertz.

Un inconvénient de cette méthode de mesure par impulsion à bande large est que l'oscillateur à actionnement électrostatique comporte une capacité parasite entre les moyens d'actionnement et les moyens de détection. Il y a donc un couplage électrique direct de la tension d'excitation vers la sortie de l'oscillateur. La tension d'excitation étant à bande large, sa densité spectrale d'amplitude se superpose alors à la densité spectrale d'amplitude du signal de réponse. Si le couplage capacitif est suffisamment important, une faible oscillation de l'oscillateur est alors noyée dans le spectre de la tension d'excitation, ce qui généralement rend cette méthode de mesure inutilisable.

Pour pallier à ce problème, à la place d'une impulsion à bande large on peut utiliser une impulsion à bande étroite pour exciter l'oscillateur. Cette impulsion à bande étroite a par exemple la forme d'une fonction sinus cardinal de largeur spectrale $\Delta F$ modulé par une fonction sinus de fréquence $F_0$. La tension d'excitation u(t) peut alors être définie par l'équation suivante :

$$u(t) = \text{sinc}(\Delta F . t) . \sin(2 . \pi . F_0 . t) \qquad (1)$$

La force d'excitation est proportionnelle au carré de la tension d'excitation u(t) et peut être exprimée par l'équation suivante :

$$F(t) = k . [\text{sinc}(\Delta F . t) . \sin(2 . \pi . F_0 . t)]^2 \qquad (2)$$

où k est un facteur de proportionnalité. L'équation (2) peut être développée pour obtenir l'équation suivante :

$$F(t) = k\left[\frac{1}{2} . \text{sinc}^2(\Delta F . t) - \frac{1}{2} . \cos(4 . \pi . F_0 . t) . \text{sinc}^2(\Delta F . t)\right] \qquad (2')$$

La force d'excitation est donc la somme d'un premier terme proportionnel au carré du sinus cardinal et d'un deuxième terme proportionnel au carré du sinus cardinal modulé à la fréquence $2F_0$.

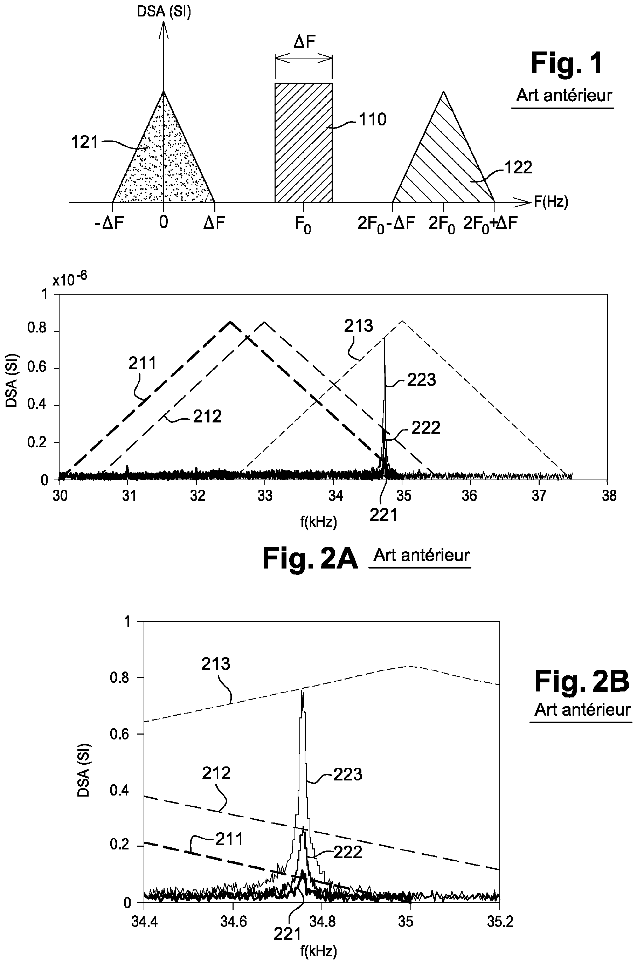

La figure 1 montre la densité spectrale d'amplitude (DSA) 110 de la tension d'excitation u(t). Cette densité spectrale 110 est une fonction porte de largeur $\Delta F$ centrée sur la fréquence $F_0$. La figure 1 montre également la densité spectrale d'amplitude de la force d'excitation F(t) qui comprend une première composante 121 et une deuxième composante 122 correspondant respectivement au premier terme et au deuxième terme de l'équation (2'). Ces composantes spectrales 121, 122 ont chacune une forme triangulaire de largeur $2\Delta F$, la première composante 121 étant centrée sur 0 Hz et la deuxième composante 122 étant centrée sur 2Fo.

La fréquence de résonance de l'oscillateur est recherchée dans une zone qui correspond à la plage de fréquence sur laquelle s'étend la deuxième composante 122. En définissant de manière appropriée la fréquence $F_0$ du sinus et la largeur spectrale $\Delta F$ du sinus cardinal, la densité spectrale d'amplitude 110 de l'impulsion excitatrice transmise par couplage capacitif ne se superpose pas avec la densité spectrale d'amplitude de la force d'actionnement électrostatique, comme illustré à la figure 1. Ainsi, la densité spectrale d'amplitude résultant du couplage capacitif de l'impulsion excitatrice n'est pas présente dans la zone de recherche de la fréquence de résonance.

Un inconvénient de cette méthode de mesure par impulsion à bande étroite est que la densité spectrale d'amplitude de la force d'excitation n'est pas constante. Elle est en effet maximale à la fréquence $2F_0$ et décroît linéairement de part et d'autre jusqu'à s'annuler à la fréquence $2F_0 - 2\Delta F$ et à la fréquence $2F_0 + 2\Delta F$. L'oscillateur est donc excité avec une force qui dépend de l'écart entre la fréquence de résonance et la fréquence $2F_0$. Ce phénomène est mis en évidence sur les figures 2A et 2B.

La figure 2A montre trois exemples de densités spectrales d'amplitude 211, 212, 213 de la force d'excitation lorsque la fréquence $F_0$ est égale respectivement à 16,25 kHz, 16,5 kHz et 17,5 kHz. La fréquence de résonance de l'oscillateur est recherchée dans la fenêtre fréquentielle formée par chacune de ces densités spectrales. A chacune des densités spectrales 211, 212, 213 de la force d'excitation correspond une densité spectrale d'amplitude 221, 222, 223 du signal de réponse acquis en sortie de l'oscillateur.

La figure 2B est un agrandissement de la figure 2A autour du pic de résonance. On constate que plus ce pic est proche du bord de la fenêtre fréquentielle, plus son amplitude est faible. La forme de la densité spectrale d'amplitude de la force électrostatique peut donc conduire à considérer que l'oscillateur n'est pas fonctionnel alors que la force d'excitation est seulement trop faible pour mettre en oscillation l'élément mobile de l'oscillateur.

## RÉSUMÉ DE L'INVENTION

Il ressort de ce qui précède qu'il existe un besoin de disposer d'une méthode à la fois rapide et fiable pour déterminer les paramètres caractéristiques d'un oscillateur à actionnement électrostatique. Les revendications 1 et 3 définissent des procédés répondant à ce besoin. Des caractéristiques additionnelles sont définies par les revendications 2 et 4-6.

Un premier aspect de l'invention concerne un procédé de détermination de paramètres caractéristiques d'un oscillateur à actionnement électrostatique, le procédé comportant les étapes suivantes :

- générer une première tension d'excitation définie comme étant la somme d'une première tension sinusoïdale et d'une impulsion de tension ;
- appliquer la première tension d'excitation en entrée de l'oscillateur ;
- acquérir dans le domaine temporel une première tension de réponse présente en sortie de l'oscillateur lorsque la première tension d'excitation est appliquée en entrée de l'oscillateur ;
- obtenir, par transformation dans le domaine fréquentiel, une première densité spectrale d'amplitude de la première tension de réponse ;
- déterminer les paramètres caractéristiques de l'oscillateur à partir de la première densité spectrale d'amplitude.

Grâce à l'invention, la caractérisation de l'oscillateur s'effectue de manière rapide en obtenant une densité spectrale d'oscillation complète en effectuant une seule acquisition du signal de réponse, cette acquisition durant quelques secondes. Il n'est dans ce cas pas nécessaire d'exciter l'oscillateur pour chaque fréquence de la densité spectrale, ni d'attendre que l'oscillateur retrouve une position de repos entre deux points de la densité spectrale. De plus, l'utilisation de la somme d'une tension sinusoïdale et d'une impulsion de tension pour exciter l'oscillateur permet d'obtenir une force d'actionnement électrostatique présentant une densité spectrale d'amplitude constante. L'enregistrement temporel doit contenir a minima une partie du lobe principal de l'excitation impulsionnelle, et de façon préférentielle l'ensemble de la durée de l'excitation impulsionnelle.

Les paramètres caractéristiques de l'oscillateur comprennent une fréquence de résonance. Selon un mode de mise en œuvre, le procédé comportant les étapes initiales suivantes :

- estimer la fréquence de résonance de l'oscillateur ;
- définir une plage de fréquence, dite « zone de recherche », dans laquelle la fréquence de résonance est recherchée, la zone de recherche étant centrée autour d'une fréquence médiane égale à la fréquence de résonance estimée, la zone de recherche présentant une largeur prédéterminée.

Un avantage est de savoir sur quelle plage de fréquence on souhaite chercher la fréquence de résonance afin de paramétrer la tension d'excitation convenablement.

Selon un mode de mise en œuvre, l'impulsion de tension est une réponse impulsionnelle finie d'un filtre passe-bas.

Selon un mode de mise en œuvre, l'impulsion de tension présente une largeur spectrale égale à la largeur de la zone de recherche, la première tension sinusoïdale présentant une première fréquence égale à la fréquence médiane. Un avantage est de faire coïncider la densité spectrale d'amplitude de la force électrostatique avec la zone de recherche de la fréquence de résonance.

Selon un mode de mise en œuvre, l'impulsion de tension se présente sous la forme d'une fonction sinus cardinal.

Selon un mode de mise en œuvre, l'impulsion de tension est une réponse impulsionnelle finie d'un filtre passe-bande, le procédé comportant également les étapes suivantes :

- générer une deuxième tension d'excitation définie comme étant la somme d'une deuxième tension sinusoïdale et de l'impulsion de tension ;
- appliquer la deuxième tension d'excitation en entrée de l'oscillateur ;
- acquérir dans le domaine temporel une deuxième tension de réponse présente en sortie de l'oscillateur lorsque la deuxième tension d'excitation est appliquée en entrée de l'oscillateur ;
- obtenir, par transformation dans le domaine fréquentiel, une deuxième densité spectrale d'amplitude de la deuxième tension de réponse ;
- reconstituer une densité spectrale d'amplitude à partir de la première densité spectrale d'amplitude et de la deuxième densité spectrale d'amplitude ;

les paramètres caractéristiques de l'oscillateur étant déterminés à partir de la densité spectrale d'amplitude reconstituée. Un avantage est de supprimer la densité spectrale d'amplitude de la tension sinusoïdale transmis par couplage capacitif à la densité spectrale d'amplitude de la tension de réponse.

Selon un mode de mise en œuvre, l'impulsion de tension se présente sous la forme d'une fonction sinus cardinal modulée par une fonction sinus.

Selon un mode de mise en œuvre, la fonction sinus cardinal présente une largeur spectrale, la fonction sinus présentant une fréquence de modulation égale à la largeur spectrale de la fonction sinus cardinal, la première tension sinusoïdale présentant une première fréquence et la deuxième tension sinusoïdale présentant une deuxième fréquence égale à la somme de la première fréquence et de la largeur spectrale de la fonction sinus cardinal. Un avantage est d'obtenir une densité spectrale reconstituée continue.

Selon un mode de mise en œuvre, la largeur spectrale de la fonction sinus cardinal est égale à un quart de la largeur de la zone de recherche, la fréquence médiane étant égale à la moitié de la somme de la première fréquence et de la deuxième fréquence.

De façon connue, la largeur spectrale peut être vue comme la fréquence de coupure d'un filtre à 3dB.

Un deuxième aspect de l'invention concerne un produit programme d'ordinateur comprenant des instructions pour la mise en œuvre du procédé selon le premier aspect de l'invention, lorsque ces instructions sont exécutées par un processeur.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1 représente schématiquement la densité spectrale d'amplitude d'une tension d'excitation appliquée en entrée d'un oscillateur et la densité spectrale d'amplitude de la force électrostatique qui en résulte, dans le cas d'une mesure par impulsion à bande étroite selon l'art antérieur ;
- la figure 2A représente schématiquement trois densités spectrales d'amplitude de la force électrostatique agissant sur un oscillateur excité au moyen d'un sinus cardinal modulé par un sinus, ainsi que les trois densités spectrales d'amplitude de la tension de réponse correspondante ;
- la figure 2B est une vue agrandie de la figure 2A autour des pics de résonances ;
- la figure 3 représente schématiquement la densité spectrale d'amplitude d'une tension d'excitation appliquée en entrée d'un oscillateur, selon un premier mode de mise en œuvre du procédé de l'invention ;
- la figure 4 représente schématiquement la densité spectrale d'amplitude de la force d'excitation produite par la tension d'excitation de la figure 3 ;
- la figure 5 est un exemple de densité spectrale d'amplitude du signal de réponse d'un oscillateur de gyromètre, obtenu avec le premier mode mise en œuvre du procédé de l'invention ;
- la figure 6 représente schématiquement les densités spectrales d'amplitude d'une première tension d'excitation et d'une deuxième tension d'excitation, selon un deuxième mode de mise en œuvre du procédé de l'invention ;
- la figure 7 représente schématiquement les densités spectrales d'amplitude de la force d'excitation produite par chacune des tensions d'excitation de la figure 6 ;
- la figure 8 est un exemple de densité spectrale d'amplitude du signal de réponse de l'oscillateur de la figure 5, obtenu avec le deuxième mode mise en œuvre du procédé de l'invention ;
- la figure 9A représente schématiquement trois densités spectrales d'amplitude de la force électrostatique agissant sur l'oscillateur de la figure 2A, ainsi que les trois densités spectrales d'amplitude de la tension de réponse correspondante, selon le deuxième mode de mise en œuvre du procédé de l'invention ;
- la figure 9B est une vue agrandie de la figure 9A autour des pics de résonances ;
- la figure 10 illustre une comparaison entre une mesure par balayage de fréquence selon l'art antérieur et une mesure selon le procédé de l'invention.

Les figures ne sont présentées qu'à titre indicatif et nullement limitatif de l'invention.
Pour plus de clarté, les éléments identiques ou similaires sont repérés par des signes de référence identiques sur toutes les figures.

## DESCRIPTION DÉTAILLÉE DE MODES DE MISE EN ŒUVRE DE L'INVENTION

Un oscillateur de type MEMS ou NEMS comporte une partie fixe et un élément mobile par rapport à la partie fixe. L'oscillateur comporte également une entrée et une sortie entre lesquelles est disposé l'élément mobile.
L'entrée de l'oscillateur est pourvue de moyens d'actionnement électrostatiques configurés pour mettre en vibration l'élément mobile. Les moyens d'actionnement transforment un signal électrique d'entrée, également appelé « signal d'excitation », appliqué en entrée de l'oscillateur en une force d'actionnement électrostatique, également appelée « force d'excitation », agissant sur l'élément mobile. Le signal d'excitation se présente par exemple sous la forme d'une tension. La force d'excitation entraîne des déplacements oscillatoires de l'élément mobile. Les moyens d'actionnement comprennent par exemple une première électrode fixe appartenant à la partie fixe et une première électrode mobile appartenant à l'élément mobile. Ces électrodes peuvent chacune avoir la forme d'un peigne et former ensemble une structure à peignes capacitifs interdigités.
La sortie de l'oscillateur est pourvue de moyens de détection des déplacements de l'élément mobile. Les moyens de détections sont configurés pour délivrer un signal électrique de sortie, également appelé « signal de réponse », qui dépend des déplacements détectés de l'élément mobile. Par exemple, les moyens de détection sont de type capacitif et comportent des moyens de mesure de capacité entre une deuxième électrode fixe appartenant à la partie fixe et une deuxième électrode mobile appartenant à l'élément mobile. Ces électrodes peuvent chacune avoir la forme d'un peigne et former ensemble une structure à peignes capacitifs interdigités.
L'oscillateur est caractérisé par une fréquence de résonance et un facteur de qualité. Ces deux paramètres sont essentiels pour valider la conception de l'oscillateur et pour son intégration dans un dispositif tel qu'un capteur inertiel, par exemple un accéléromètre ou un gyromètre.
Lorsque l'oscillateur est excité à la fréquence de résonance, l'amplitude des oscillations de l'élément mobile est maximale. Lorsque le signal d'excitation n'est plus appliqué, les oscillations de l'élément mobile s'amortissent jusqu'à ce que l'élément mobile retrouve une position de repos dans laquelle l'élément mobile cesse de se mouvoir. L'amortissement dans le temps t des oscillations dépend d'un terme exponentiel $e^{-\frac{t}{2\tau}}$ où $\tau$ est une constante d'amortissement, ou temps de relaxation, définissant la vitesse avec laquelle l'amplitude des oscillations décroît après excitation.
Le facteur de qualité Q de l'oscillateur est défini par la relation suivante :

$$Q = \pi . F_R . \tau$$

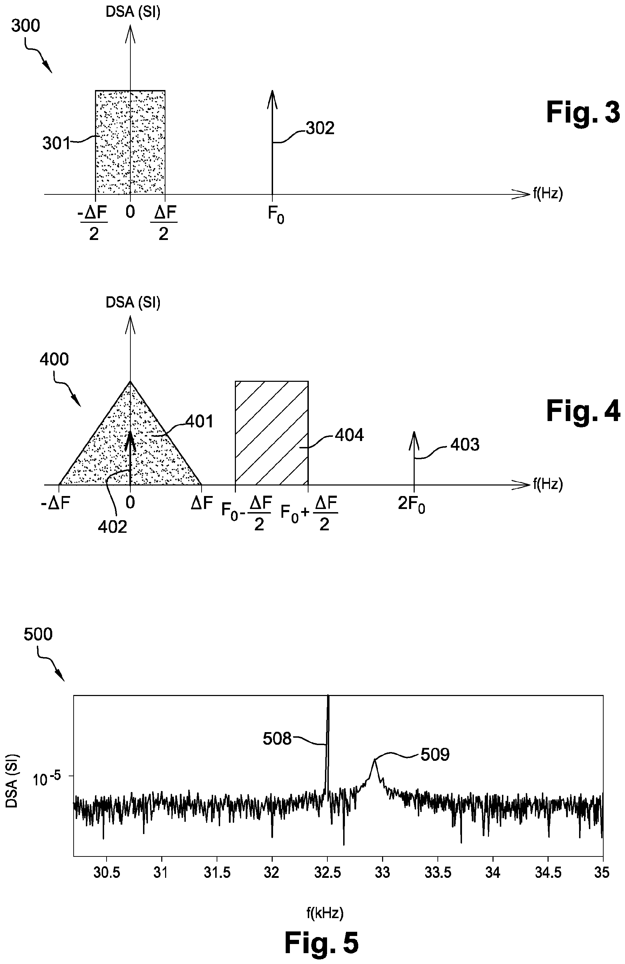

où $F_R$ est la fréquence de résonance de l'oscillateur. Le facteur de qualité traduit notamment la précision du capteur dans lequel l'oscillateur est intégré. Plus le facteur de qualité est élevé, plus la précision l'est aussi.
La présente invention a pour objectif principal de proposer un procédé de détermination des paramètres caractéristiques de l'oscillateur, ce procédé étant à la fois rapide et fiable. Le procédé selon l'invention vise en particulier à déterminer la fréquence de résonance et le facteur de qualité de l'oscillateur. Dans ce procédé, l'oscillateur est excité par une tension d'excitation qui résulte de la somme d'une tension sinusoïdale et d'une impulsion de tension.
Un premier mode de mise en œuvre du procédé selon l'invention va maintenant être décrit, en référence aux figures 3 à 5. Le procédé comporte une étape de génération de la tension d'excitation. La tension d'excitation est par exemple fournie par un générateur de signal connecté électriquement à l'entrée de l'oscillateur. Selon le premier mode de mise en œuvre, la tension d'excitation est la somme d'une tension sinusoïdale de fréquence $F_0$ constante et d'une réponse impulsionnelle finie d'un filtre passe-bas. La réponse impulsionnelle a de préférence la forme d'une fonction sinus cardinal de largeur spectrale $\Delta F$, la tension d'excitation u(t) pouvant alors être définie par l'équation suivante :

$$u(t) = A . \mathrm{sinc}(\Delta F . t) + B . \sin(2 . \pi . F_0 . t) \qquad (3)$$

où A et B sont l'amplitude respectivement du sinus cardinal et de la tension sinusoïdale.

Alternativement, la réponse impulsionnelle peut être celle de tout type de filtre passe-bas tel qu'une fenêtre de Hamming, de Hanning, de Tchebychev, de Bartlett, ou de Blackman.

La figure 3 représente schématiquement la densité spectrale d'amplitude 300 de la tension d'excitation u(t), par exemple calculée au moyen d'une transformée de Fourier. Une densité spectrale d'amplitude (DSA) est exprimée en unité par racine de hertz, c'est-à-dire en volt par racine de hertz ($V.Hz^{-0,5}$) lorsqu'il s'agit de la densité spectrale d'amplitude d'une tension d'excitation, et en newton par racine de hertz ($N.Hz^{-0,5}$) lorsqu'il s'agit de la densité spectrale d'amplitude d'une force d'excitation.

La densité spectrale d'amplitude 300 de la tension d'excitation comporte :

- une première composante 301 correspondant à la densité spectrale du sinus cardinal, la première composante 301 étant une fonction porte centrée sur 0 Hz et de largeur spectrale $\Delta F$ ;
- une deuxième composante 302 correspondant à la densité spectrale de la tension sinusoïdale, la deuxième composante 302 étant un pic de Dirac situé à la fréquence $F_0$.

La tension d'excitation est appliquée en entrée de l'oscillateur pour le mettre en oscillation. La force d'excitation qui en résulte est proportionnelle au carré de la tension d'excitation. La force d'excitation F(t) peut ainsi être exprimée par l'équation suivante :

$$F(t) = k \left[ A.\text{sinc}^2(\Delta F.t) + \frac{B^2}{2} - \frac{B^2}{2}.\cos(4.\pi.F_0.t) + \right.$$
$$\left. 2.A.B.\text{sinc}(\Delta F.t).\sin(2.\pi.F_0.t) \right] \qquad (4)$$

où k est un coefficient de proportionnalité. La force d'excitation est donc la somme d'un premier terme proportionnel au carré du sinus cardinal, d'un deuxième terme égal à une constante, d'un troisième terme proportionnel à une fonction sinusoïdale de fréquence $2F_0$, et d'un quatrième terme proportionnel au sinus cardinal modulé à la fréquence $F_0$.

La figure 4 représente schématiquement la densité spectrale d'amplitude 400 de la force d'excitation F(t) obtenue par transformation dans le domaine fréquentiel, par exemple au moyen d'une transformée de Fourier. La densité spectrale d'amplitude 400 comprend :

- une première composante 401 correspondant à la densité spectrale d'amplitude du premier terme de l'équation (4), la première composante 401 ayant une forme triangulaire centrée sur 0 Hz et de largeur spectrale $2\Delta F$ ;
- une deuxième composante 402 correspondant à la densité spectrale d'amplitude du deuxième terme de l'équation (4), la deuxième composante 402 étant un pic de Dirac situé à 0 Hz ;
- une troisième composante 403 correspondant à la densité spectrale d'amplitude du troisième terme de l'équation (4), la troisième composante 403 étant un pic de Dirac situé à la fréquence $2F_0$ ;
- une quatrième composante 404 correspondant à la densité spectrale d'amplitude du quatrième terme de l'équation (4), la quatrième composante 404 étant une fonction porte centrée sur la fréquence $F_0$ et de largeur spectrale $\Delta F$.

La fréquence de résonance de l'oscillateur est recherchée dans une plage de fréquence dite « zone de recherche » définie par la fréquence $F_0$ de la tension sinusoïdale et par la largeur spectrale $\Delta F$ de la fonction sinus cardinal. La zone de recherche s'étend entre une fréquence minimale égale à $F_0 - \frac{\Delta F}{2}$ et une fréquence maximale égale à $F_0 + \frac{\Delta F}{2}$.

Initialement, il est possible d'estimer la fréquence de résonance de l'oscillateur, en se basant notamment sur sa conception. La fréquence $F_0$ de la tension sinusoïdale peut alors être définie de sorte que la fréquence de résonance estimée se trouve dans la zone de recherche, et en particulier que la zone de recherche soit centrée sur la fréquence de résonance estimée. De même, la largeur spectrale $\Delta F$ de la fonction sinus cardinal peut être définie pour adapter la largeur de la zone de recherche.

La tension d'excitation appliquée en entrée de l'oscillateur est transmise en sortie de l'oscillateur par couplage capacitif dû à une capacité parasite présente entre l'entrée et la sortie de l'oscillateur. La largeur spectrale $\Delta F$ de la réponse impulsionnelle est de préférence inférieure à F0-$\Delta F$/2 de manière à éviter que ce signal parasite, qui a une amplitude plus élevée, ne recouvre le signal issu de la résonance.

Lorsque la tension d'excitation est appliquée à l'oscillateur, on procède à une étape d'acquisition dans le domaine temporel du signal de réponse de l'oscillateur fourni par les moyens de détection. Pour ce faire, des moyens d'acquisitions sont connectés électriquement à la sortie de l'oscillateur. Les moyens d'acquisition peuvent être une carte électronique d'acquisition ou un oscilloscope numérique. Le signal de réponse se présente par exemple sous la forme d'une tension.

L'acquisition est effectuée avec une fréquence d'échantillonnage configurée pour respecter le critère de Shannon. La fréquence d'échantillonnage dépend ici de la fréquence $F_0$ de la tension sinusoïdale et de la largeur spectrale $\Delta F$ de la réponse impulsionnelle, la fréquence d'échantillonnage $F_e$ devant respecter l'inégalité suivante :

$$F_e \geq 2.\left(F_0 + \frac{\Delta F}{2}\right)$$

La tension de réponse acquise est ensuite transformée dans le domaine fréquentiel pour obtenir sa densité spectrale d'amplitude. La densité spectrale d'amplitude de la tension de réponse est par exemple calculée au moyen d'une transformée de Fourier. A partir de cette densité spectrale d'amplitude, il est possible de déterminer la fréquence de résonance et le facteur de qualité de l'oscillateur.

La figure 5 montre un exemple de la densité spectrale d'amplitude 500 de la tension de réponse d'un oscillateur d'un gyromètre, obtenue grâce au premier mode de mise en œuvre qui vient d'être décrit. Dans ce cas, la fréquence $F_0$ de la tension sinusoïdale est égale à 32,5 kHz et la largeur spectrale $\Delta F$ du sinus cardinal est égale à 5 kHz. La zone de recherche de la fréquence de résonance s'étend donc de 30 kHz à 35 kHz. La figure 5 met en évidence un pic de résonance 509 à la fréquence de résonance $F_R$ approximativement égale à 32.9 kHz.

Une fois la fréquence de résonance connue, le facteur de qualité peut être déterminé par une mesure du décrément logarithmique qui consiste à mesurer le temps d'amortissement après une excitation de l'oscillateur par une tension sinusoïdale à la fréquence de résonance. Le facteur de qualité peut également être déterminé en calculant le rapport de la fréquence de résonance sur la largeur du pic de résonance 509 mesurée à la moitié de sa hauteur.

La tension d'excitation appliquée en entrée de l'oscillateur est transmise en sortie de l'oscillateur par couplage capacitif. Un inconvénient de ce premier mode de mise en œuvre est donc que le pic de Dirac 302 appartenant à la densité spectrale d'amplitude 300 de la tension d'excitation se retrouve dans la zone de recherche de la fréquence de résonance, ce pic 302 étant en effet présent à la fréquence $F_0$. Il s'agit d'un inconvénient mineur car ce pic de Dirac 302 présente une faible largeur spectrale, inférieure à quelques dixièmes de hertz, alors que la zone de recherche s'étend sur une largeur de préférence supérieure à 1 kHz. Le phénomène de couplage capacitif est visible sur la figure 5 sous la forme d'un pic d'amplitude 508 présent à la fréquence $F_0$ ici égale à 32,5 kHz.

Toutefois, un deuxième mode de mise en œuvre du procédé de l'invention permet de remédier à cet inconvénient. Selon ce deuxième mode de mise en œuvre, l'impulsion de tension utilisée pour former la tension d'excitation n'est plus une réponse impulsionnelle d'un filtre passe-bas, mais celle d'un filtre passe-bande. De préférence, cette réponse impulsionnelle a la forme d'une fonction sinus cardinal de largeur spectrale $\Delta F$ modulée par une fonction sinus de fréquence de modulation $\Delta F'$.

Selon ce deuxième mode de mise en œuvre, on génère ainsi une première tension d'excitation et une deuxième tension d'excitation en additionnant l'impulsion de tension respectivement à une première tension sinusoïdale ayant première fréquence $F_1$ et à une deuxième tension sinusoïdale ayant une deuxième fréquence $F_2$. De préférence la première tension sinusoïdale et la deuxième tension sinusoïdale ont la même amplitude de manière à obtenir des forces d'excitation ayant la même amplitude. La première tension d'excitation $u_1(t)$ et la deuxième tension d'excitation $u_2(t)$ peuvent être définies par les équations suivantes :

$$u_1(t) = A.\operatorname{sinc}(\Delta F.t)\sin(2.\pi.\Delta F'.t) + B.\sin(2.\pi.F_1.t) \qquad (6.1)$$

$$u_2(t) = A.\operatorname{sinc}(\Delta F.t)\sin(2.\pi.\Delta F'.t) + B.\sin(2.\pi.F_2.t) \qquad (6.2)$$

où A est l'amplitude du sinus cardinal et B est l'amplitude des tensions sinusoïdales.

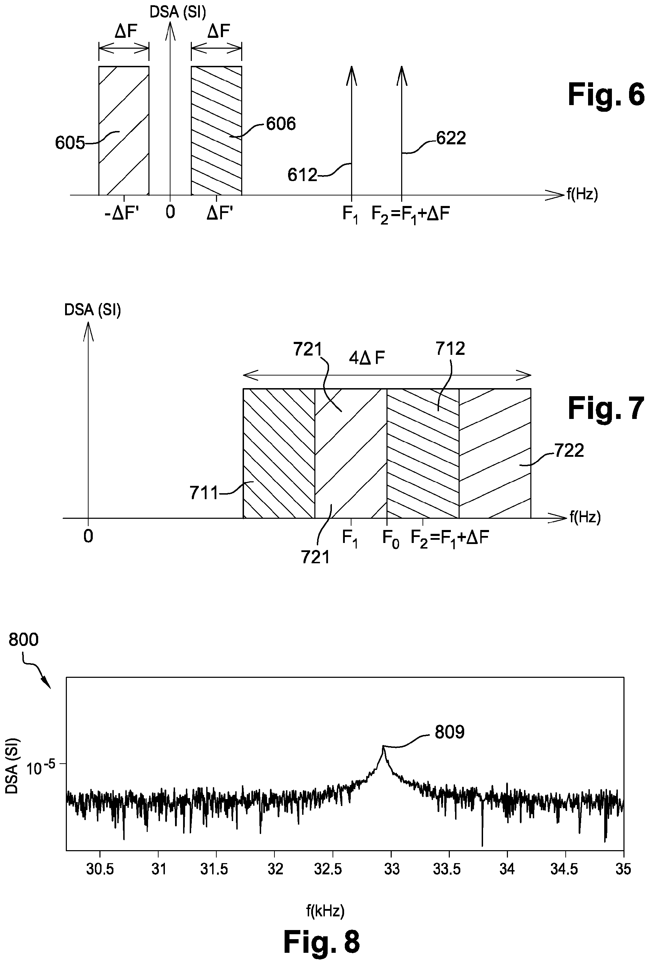

La figure 6 représente schématiquement les densités spectrales d'amplitude de la première tension d'excitation $u_1(t)$ et de la première tension d'excitation $u_2(t)$, par exemple calculées au moyen d'une transformée de Fourier. Ces densités spectrales comportent chacune :

- deux premières composantes 605, 606 correspondant à la densité spectrale d'amplitude du sinus cardinal modulé à la fréquence $\Delta F'$, ces composantes 605, 606 étant des fonctions porte de largeur spectrale $\Delta F$ centrées respec-

tivement sur -ΔF' et sur +ΔF' ;

- une deuxième composante 612, 622 correspondant respectivement à la densité spectrale d'amplitude de la première tension sinusoïdale et à la densité spectrale d'amplitude de la deuxième tension sinusoïdale, la deuxième composante 612, 622 étant un pic de Dirac situé à la fréquence $F_1$ dans le cas de la première tension d'excitation et à la fréquence $F_2$ dans le cas de la deuxième tension d'excitation.

La première tension d'excitation et la deuxième tension d'excitation sont successivement appliquées en entrée de l'oscillateur. Il en résulte respectivement une première force d'excitation $F_1(t)$ et une deuxième force d'excitation $F_2(t)$ qui s'exercent successivement sur l'élément mobile de l'oscillateur et qui peuvent être exprimées par les équations suivantes :

$$F_1(t) = k\left[A^2.\text{sinc}^2(\Delta F.t).\left(\frac{1-\cos(4.\pi.F_1.t)}{2}\right) + \frac{B^2}{2} - \frac{B^2}{2}.\cos(4.\pi.F_1.t) + \right.$$
$$\left. 2.A.B.\text{sinc}(\Delta F.t).\sin(2.\pi.\Delta F'.t).\sin(2.\pi.F_1.t)\right] \qquad (7.1)$$

$$F_2(t) = k\left[A^2.\text{sinc}^2(\Delta F.t).\left(\frac{1-\cos(4.\pi.F_2.t)}{2}\right) + \frac{B^2}{2} - \frac{B^2}{2}.\cos(4.\pi.F_2.t) + \right.$$
$$\left. 2.A.B.\text{sinc}(\Delta F.t).\sin(2.\pi.\Delta F'.t).\sin(2.\pi.F_2.t)\right] \qquad (7.2)$$

où k est un coefficient de proportionnalité. Ces équations qui expriment les forces d'excitation comportent chacune un dernier terme proportionnel au produit de l'impulsion de tension et de la tension sinusoïdale.

La figure 7 représente schématiquement et partiellement la superposition des densités spectrales d'amplitude de la première force d'excitation $F_1(t)$ et de la deuxième force d'excitation $F_2(t)$. La figure 7 montre seulement les composantes spectrales à partir desquelles la zone de recherche de la fréquence de résonance est reconstituée. La densité spectrale d'amplitude de la première force d'excitation comporte deux composantes 711, 712 correspondant à la densité spectrale d'amplitude du dernier terme de l'équation (7.1), ces composantes 711, 712 étant des fonctions porte de largeur spectrale ΔF centrées respectivement sur les fréquences $F_1 - \Delta F'$ et sur $F_1 + \Delta F'$. Similairement, la densité spectrale d'amplitude de la deuxième force d'excitation comporte deux composantes 721, 722 correspondant à la densité spectrale d'amplitude du dernier terme de l'équation (7.2), ces composantes 721, 722 étant des fonctions porte de largeur spectrale ΔF centrées respectivement sur les fréquences $F_2 - \Delta F'$ et sur $F_2 + \Delta F'$.

La zone de recherche ainsi obtenue est centrée sur une fréquence médiane $F_0$ égale à la moitié de la somme de la première fréquence et de la deuxième fréquence $\left(F_0 = \frac{F_1+F_2}{2}\right)$. Avantageusement, la fréquence de modulation ΔF' de la fonction sinus est égale à la largeur spectrale ΔF de la fonction sinus cardinal (ΔF' = ΔF), et la deuxième fréquence $F_2$ est égale à la somme de la première fréquence $F_1$ et de la largeur spectrale ΔF ($F_2 = F_1 + \Delta F$). La zone de recherche est ainsi continue et présente une largeur égale à quatre fois la largeur spectrale ΔF.

Si la fréquence de modulation ΔF' de la fonction sinus est inférieure à la largeur spectrale ΔF de la fonction sinus cardinal (ΔF' < ΔF) et/ou si la deuxième fréquence $F_2$ est inférieure à la somme de la première fréquence $F_1$ et de la largeur spectrale ΔF ($F_2 < F_1 + \Delta F$), il y a un recouvrement entre les composantes spectrales. Dans ce cas, il y a une redondance inutile d'information dans la zone de recouvrement.

Au contraire, si la fréquence de modulation ΔF' de la fonction sinus est supérieure à la largeur spectrale ΔF de la fonction sinus cardinal (ΔF' > ΔF) et/ou si la deuxième fréquence $F_2$ est supérieure à la somme de la première fréquence $F_1$ et de la largeur spectrale ΔF ($F_2 > F_1 + \Delta F$), la densité spectrale reconstituée n'est plus continue et est donc nulle dans certaines bandes de fréquences, ce qui peut conduire à manquer la fréquence de résonance.

Selon le deuxième mode de mise en œuvre, le procédé comporte une première étape d'acquisition dans le domaine temporel d'une première tension de réponse présente en sortie de l'oscillateur lorsque la première tension d'excitation est appliquée en entrée de l'oscillateur, et une deuxième étape d'acquisition dans le domaine temporel d'une deuxième tension de réponse présente en sortie de l'oscillateur lorsque la deuxième tension d'excitation est appliquée en entrée de l'oscillateur. Pour avoir une même résolution d'une acquisition à l'autre, les étapes d'acquisition sont de préférences effectuées avec une même fréquence d'échantillonnage $F_e$ telle que :

$$F_e \geq 2.(F_0 + 2.\Delta F)$$

La première tension de réponse et la deuxième tension de réponse sont transformées dans le domaine fréquentiel pour obtenir respectivement une première densité spectrale d'amplitude et une deuxième densité spectrale d'amplitude. Ces densités spectrales d'amplitude sont par exemple calculées au moyen d'une transformée de Fourier.

La première densité spectrale et la deuxième densité spectrale sont filtrées pour ne conserver que les portions de spectre correspondant aux composantes spectrales représentées aux figures 7A et 7B. Il s'agit par exemple d'un filtrage numérique. Une densité spectrale d'amplitude est ensuite reconstituée en superposant les portions de spectre conservées. Les pics de Dirac présents aux fréquences $F_1$ et $F_2$, qui sont dus au couplage capacitif, sont ainsi éliminés de la densité spectrale d'amplitude reconstituée. La densité spectrale d'amplitude reconstituée est équivalente à celle qu'on obtiendrait avec une force électrostatique non perturbée par le couplage capacitif.

La figure 8 montre un exemple de la densité spectrale d'amplitude 800 de la tension de réponse du même oscillateur que pour la figure 5, obtenue grâce au deuxième mode de mise qui vient d'être décrit. Dans ce cas, la fréquence médiane $F_0$ de la zone de recherche est égale à 32,5 kHz. La largeur spectrale $\Delta F$ de la fonction sinus cardinal et la fréquence de modulation $\Delta F'$ de la fonction sinus sont égales à 1,25 kHz. Par conséquent la première fréquence $F_1$ est égale à 31,875 kHz et la deuxième fréquence $F_2$ est égale à 33,125 kHz. La zone de recherche de la fréquence de résonance s'étend donc de 30 kHz à 35 kHz. Un pic de résonance 809 est toujours présent à la fréquence de résonance $F_R$ approximativement égale à 32.9 kHz. Par contre, les pics de Dirac 612, 622 appartenant aux densités spectrales d'amplitude 610, 620 de la première tension d'excitation et de la deuxième tension d'excitation sont bien absents.

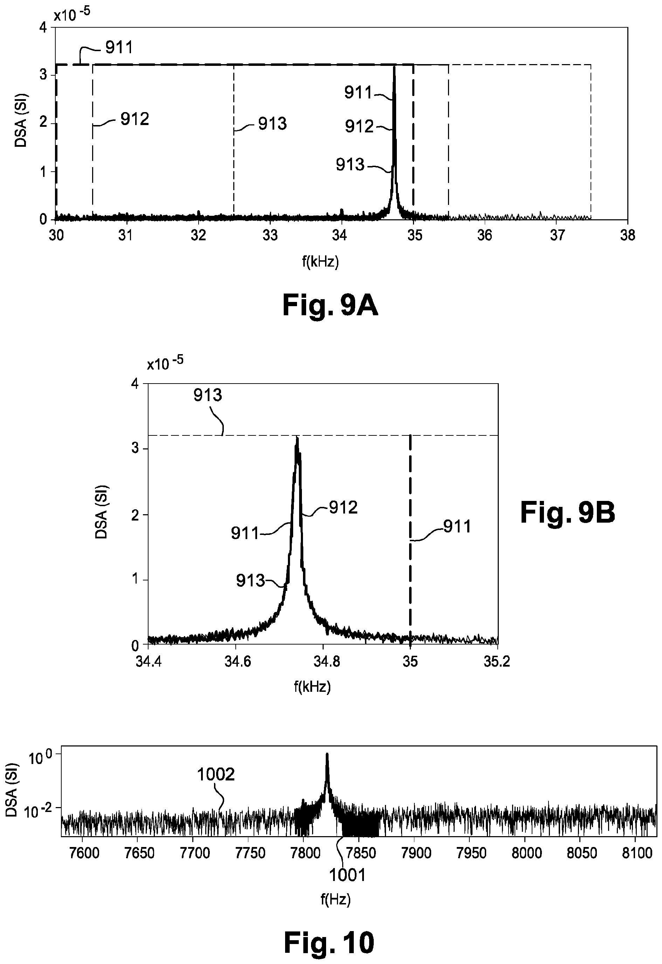

La figure 9A montre trois exemples de densités spectrales d'amplitude 911, 912, 913 d'une force d'excitation formées selon le deuxième mode de mise en œuvre. La fréquence médiane $F_0$ de la zone de recherche définie par ces densités spectrales 911, 912, 913 est respectivement égale respectivement à 32,5 kHz, 33 kHz et 34 kHz. A chacun de ces spectres 911, 912, 913 correspond une densité spectrale d'amplitude reconstituée 921, 922, 923 de la tension de réponse de l'oscillateur.

Grâce à l'utilisation de la somme du sinus cardinal et de la tension sinusoïdale en tant que tension d'excitation, l'amplitude des densités spectrales 911, 912, 913 est constante sur toute la zone de recherche. Par conséquent, les densités spectrales reconstituées 921, 922, 923 comportent chacune un pic de résonance ayant la même amplitude, comme mieux visible sur la figure 9B. L'amplitude du pic ne dépend donc pas de sa position par rapports aux bords de la zone de recherche, contrairement au cas de l'art antérieur illustré sur les figures 2A et 2B.

La figure 10 montre une densité spectrale d'amplitude 1001 de la tension de réponse d'un oscillateur obtenue par la méthode de balayage en fréquence de l'art antérieur. Dans ce cas, la mesure a duré environ 81 minutes pour une plage de fréquence de 75 Hz et un pas en fréquence de 0,02 Hz. La figure 10 montre également, pour le même oscillateur, une densité spectrale d'amplitude 1002 de la tension de réponse obtenue par le procédé de l'invention. Dans ce cas, la mesure a duré environ 40 secondes pour une plage de fréquence de 500 Hz et un pas en fréquence de 0,25Hz (cette courbe 1002 est en fait le résultat de la moyenne de 10 courbes correspondant chacune à un temps d'acquisition de 4s à la fréquence d'échantillonnage de 25 kHz ; en effectuant la moyenne de plusieurs acquisitions, le bruit est réduit). On constate que les pics de résonances des deux densités spectrales d'amplitude 1001, 1002 sont superposés par contre le procédé de l'invention permet de caractériser l'oscillateur beaucoup plus rapidement.

Le procédé selon l'invention est par exemple mis en œuvre par le biais d'une application. Une application désigne un programme d'ordinateur comprenant des instructions exécutables par un processeur.

**Revendications**

1. Procédé de détermination d'une fréquence de résonance et d'un facteur de qualité d'un oscillateur à actionnement électrostatique, le procédé comportant les étapes suivantes :

   - estimer la fréquence de résonance de l'oscillateur ;
   - définir une plage de fréquence, dite « zone de recherche », dans laquelle la fréquence de résonance est recherchée, la zone de recherche étant centrée autour de la fréquence de résonance estimée ;
   - générer une tension d'excitation définie comme étant la somme d'une tension sinusoïdale présentant une fréquence constante, $F_0$, égale à la fréquence de résonnance estimée et d'une réponse impulsionnelle finie d'un filtre passe-bas présentant une largeur spectrale, $\Delta F$, égale à la largeur de la zone de recherche ;
   - appliquer la tension d'excitation en entrée de l'oscillateur ;
   - acquérir dans le domaine temporel une tension de réponse présente en sortie de l'oscillateur lorsque la tension d'excitation est appliquée en entrée de l'oscillateur ;
   - obtenir, par transformation dans le domaine fréquentiel, une densité spectrale d'amplitude (500) de la tension de réponse ;
   - déterminer la fréquence de résonnance et le facteur de qualité de l'oscillateur à partir de la densité spectrale d'amplitude (500).

**2.** Procédé selon la revendication 1, dans lequel la réponse impulsionnelle du filtre passe-bas se présente sous la forme d'une fonction sinus cardinal.

**3.** Procédé de détermination d'une fréquence de résonance et d'un facteur de qualité d'un oscillateur à actionnement électrostatique, le procédé comportant les étapes suivantes :

- estimer la fréquence de résonance de l'oscillateur ;
- définir une plage de fréquence, dite « zone de recherche », dans laquelle la fréquence de résonance est recherchée, la zone de recherche étant centrée autour de la fréquence de résonance estimée ;
- générer une première tension d'excitation définie comme étant la somme :

  ◦ d'une tension sinusoïdale présentant une première fréquence constante, F1 ; et
  ◦ d'une réponse impulsionnelle finie d'un filtre passe-bande présentant une largeur spectrale, $\Delta F$, égale à un quart de la largeur de la zone de recherche ;

- générer une deuxième tension d'excitation définie comme étant la somme :

  ◦ d'une tension sinusoïdale présentant une deuxième fréquence constante, F2, telle que la somme de la première fréquence et de la deuxième fréquence est égale au double de la fréquence médiane sur laquelle est centrée la zone de recherche ; et
  ◦ d'une réponse impulsionnelle finie d'un filtre passe-bande présentant une largeur spectrale, $\Delta F$, égale à un quart de la largeur de la zone de recherche ;

- appliquer successivement la première tension d'excitation et la deuxième tension d'excitation en entrée de l'oscillateur ;
- acquérir dans le domaine temporel une première tension de réponse et une deuxième tension de réponse présentes successivement en sortie de l'oscillateur lorsque la première tension d'excitation et la deuxième tension d'excitation sont respectivement appliquées en entrée de l'oscillateur ;
- obtenir, par transformation dans le domaine fréquentiel, une première densité spectrale d'amplitude de la première tension de réponse et une deuxième densité spectrale d'amplitude de la deuxième tension de réponse ;
- reconstituer une densité spectrale d'amplitude (800) à partir de la première densité spectrale d'amplitude et de la deuxième densité spectrale d'amplitude ;

la fréquence de résonance et le facteur de qualité de l'oscillateur étant déterminés à partir de la densité spectrale d'amplitude reconstituée (800).

**4.** Procédé selon la revendication précédente, dans lequel la réponse impulsionnelle du filtre passe-bande se présente sous la forme d'une fonction sinus cardinal modulée par une fonction sinus.

**5.** Procédé selon la revendication précédente, dans lequel la fonction sinus présente une fréquence de modulation, $\Delta F'$, égale à la largeur spectrale, $\Delta F$, de la fonction sinus cardinal, la différence entre la première fréquence et la deuxième fréquence de la tension sinusoïdale étant égale à la largeur spectrale, $\Delta F$, de la fonction sinus cardinal, la densité spectrale d'amplitude reconstituée (800) étant continue.

**6.** Produit programme d'ordinateur comprenant des instructions pour la mise en œuvre d'un procédé selon l'une quelconque des revendications 1 à 5, lorsque ces instructions sont exécutées par un processeur.

**Patentansprüche**

**1.** Verfahren zur Bestimmung einer Resonanzfrequenz und eines Qualitätsfaktors eines Oszillators mit elektrostatischer Betätigung, wobei das Verfahren die folgenden Schritte aufweist:

- Schätzen der Resonanzfrequenz des Oszillators;
- Definieren eines Frequenzbereichs, bezeichnet als "Suchzone", in der die Resonanzfrequenz gesucht wird, wobei die Suchzone um die geschätzte Resonanzfrequenz zentriert ist;

- Erzeugen einer Erregungsspannung, die als Summe einer Sinusspannung, die eine konstante Frequenz F0 gleich der geschätzten Resonanzfrequenz aufweist, und einer endlichen Impulsantwort eines Tiefpassfilters, der eine Spektralbreite ΔF gleich der Breite der Suchzone aufweist, definiert ist;
- Anwenden der Erregungsspannung am Eingang des Oszillators;
- Erfassen, in der Zeitdomäne, einer Antwortspannung, die am Ausgang des Oszillators vorhanden ist, wenn die Erregungsspannung am Eingang des Oszillators angewendet wird;
- Erhalten, durch Transformation in der Frequenzdomäne, einer amplitudenspektralen Dichte (500) der Antwortspannung;
- Bestimmen der Resonanzfrequenz und des Qualitätsfaktors des Oszillators auf der Basis der amplitudenspektralen Dichte (500).

2. Verfahren nach Anspruch 1, wobei die Impulsantwort des Tiefpassfilters in Form einer Kardinalsinusfunktion vorliegt.

3. Verfahren zur Bestimmung einer Resonanzfrequenz und eines Qualitätsfaktors eines Oszillators mit elektrostatischer Betätigung, wobei das Verfahren die folgenden Schritte aufweist:

- Schätzen der Resonanzfrequenz des Oszillators;
- Definieren eines Frequenzbereichs, bezeichnet als "Suchzone", in der die Resonanzfrequenz gesucht wird, wobei die Suchzone um die geschätzte Resonanzfrequenz zentriert ist;
- Erzeugen einer ersten Erregungsspannung, die definiert ist als die Summe:

   ◦ einer Sinusspannung, die eine erste konstante Frequenz F1 aufweist; und
   ◦ einer endlichen Impulsantwort eines Bandpassfilters, aufweisend eine Spektralbreite ΔF gleich einem Viertel der Breite der Suchzone;

- Erzeugen einer zweiten Erregungsspannung, die definiert ist als die Summe:

   ◦ einer Sinusspannung, die eine zweite konstante Frequenz F2 derart aufweist, dass die Summe der ersten Frequenz und der zweiten Frequenz gleich dem Doppelten der Mittenfrequenz ist, auf der die Suchzone zentriert ist; und
   ◦ einer endlichen Impulsantwort eines Bandpassfilters, aufweisend eine Spektralbreite ΔF gleich einem Viertel der Breite der Suchzone;

- aufeinanderfolgendes Anwenden der ersten Erregungsspannung und der zweiten Erregungsspannung am Eingang des Oszillators;
- Erfassen, in der Zeitdomäne, einer ersten Antwortspannung und einer zweiten Antwortspannung, die aufeinanderfolgend am Ausgang des Oszillators vorhanden sind, wenn die erste Erregungsspannung und die zweite Erregungsspannung jeweils am Eingang des Oszillators angewendet werden;
- Erhalten, durch Transformation in der Frequenzdomäne, einer ersten amplitudenspektralen Dichte der ersten Antwortspannung und einer zweiten amplitudenspektralen Dichte der zweiten Antwortspannung;
- Wiederherstellen einer amplitudenspektralen Dichte (800) auf der Basis der ersten amplitudenspektralen Dichte und der zweiten amplitudenspektralen Dichte;

wobei die Resonanzfrequenz und der Qualitätsfaktor des Oszillators auf der Basis der wiederhergestellten amplitudenspektralen Dichte (800) bestimmt werden.

4. Verfahren nach vorangehendem Anspruch, wobei die Impulsantwort des Bandpassfilters in Form einer durch eine Sinusfunktion modulierten Kardinalsinusfunktion vorliegt.

5. Verfahren nach vorangehendem Anspruch, wobei die Sinusfunktion eine Modulationsfrequenz ΔF' gleich der Spektralbreite ΔF der Kardinalsinusfunktion aufweist, wobei die Differenz zwischen der ersten Frequenz und der zweiten Frequenz der Sinusspannung gleich der Spektralbreite ΔF der Kardinalsinusfunktion ist, wobei die wiederhergestellte amplitudenspektrale Dichte (800) kontinuierlich ist.

6. Rechnerprogrammprodukt, umfassend Befehle für die Durchführung eines Verfahrens nach einem der Ansprüche 1 bis 5, wenn diese Befehle von einem Prozessor ausgeführt werden.

**Claims**

1. Method for determining a resonant frequency and a quality factor of an electrostatic actuation oscillator, the method comprising the following steps:

   - estimate the oscillator's resonant frequency;
   - define a frequency range, called the "search zone", in which the resonant frequency is sought, the search zone being centred on an estimated resonant frequency;
   - generate an excitation voltage defined as the sum of a sinusoidal voltage having a constant frequency, $F_0$, equal to the estimated resonant frequency and a finite pulse response of a low-pass filter having a spectral width, $\Delta F$, equal to the width of the search zone;
   - apply the excitation voltage at the input of the oscillator;
   - acquire in the time domain a response voltage present at the output of the oscillator when the excitation voltage is applied at the input of the oscillator;
   - obtain, by transformation in the frequency domain, an amplitude spectral density (500) of the response voltage;
   - determine the resonant frequency and the quality factor of the oscillator from the amplitude spectral density (500).

2. Method according to claim 1, wherein the pulse response of the low-pass filter has the form of a cardinal sine function.

3. Method for determining a resonant frequency and a quality factor of an electrostatic actuation oscillator, the method comprising the following steps:

   - estimate the oscillator's resonant frequency;
   - define a frequency range, called the "search zone", in which the resonant frequency is sought, the search zone being centred on an estimated resonant frequency;
   - generate a first excitation voltage defined as the sum:

     ∘ of a sinusoidal voltage having a first constant frequency, F1; and
     ∘ of a finite pulse response of a band-pass filter having a spectral width, $\Delta F$, equal to one quarter of the width of the search zone;

   - generate a second excitation voltage defined as the sum:

     ∘ of a sinusoidal voltage having a second constant frequency, F2, such that the sum of the first frequency and the second frequency is equal to twice the median frequency on which the search zone is centred; and
     ∘ of a finite pulse response of a band-pass filter having a spectral width, $\Delta F$, equal to one quarter of the width of the search zone;

   - apply successively the first excitation voltage and the second excitation voltage at the input of the oscillator;
   - acquire in the time domain a first response voltage and a second response voltage present successively at the output of the oscillator when the first excitation voltage and the second excitation voltage are applied respectively at the input of the oscillator;
   - obtain, by transformation in the frequency domain, a first amplitude spectral density of the first response voltage and a second amplitude spectral density of the second response voltage;
   - reconstitute an amplitude spectral density (800) from the first amplitude spectral density and the second amplitude spectral density;

   the resonant frequency and the quality factor of the oscillator are determined from the reconstituted amplitude spectral density (800).

4. Method according to the previous claim, wherein the pulse response of the band-pass filter has the form of a cardinal sine function modulated by a sine function.

5. Method according to the previous claim, wherein the sine function has a modulation frequency, $\Delta F'$, equal to the spectral width, $\Delta F$, of the cardinal sine function, the difference between the first frequency and the second frequency of the sinusoidal voltage being equal to the spectral width, $\Delta F$, of the cardinal sine function, the reconstituted amplitude spectral density (800) being continuous.

6. Computer program product comprising instructions for implementing a method according to any of claims 1 to 5, when these instructions are executed by a processor.

**Fig. 1**
Art antérieur

**Fig. 2A** Art antérieur

**Fig. 2B**
Art antérieur

Fig. 3

Fig. 4

Fig. 5

Fig. 6

Fig. 7

Fig. 8

**Fig. 9A**

**Fig. 9B**

**Fig. 10**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **WEN-MING ZHANG et al.** Nonlinear Dynamic Analysis of Electrostatically Actuated Resonant MEMS Sensors Under Parametric Excitation. *IEEE Sensors Journal,* 01 Mars 2007, vol. 7 (3), 370-380